# FASCICULE DE BREVET EUROPEEN

(11) **EP 4 254 687 B1**
(45) Date de publication et mention de la délivrance du brevet: **05.06.2024**
(21) Numéro de dépôt: 23164948.4
(22) Date de dépôt: 29.03.2023
(51) Int. Cl.: H01S 5/02, H01S 5/042, H01S 5/10, H01S 5/14, H01S 5/34, H01S 5/125

(54) **DISPOSITIF OPTOELECTRONIQUE COMPORTANT UNE SOURCE LASER A MEMBRANE SEMICONDUCTRICE III-V FORMANT UNE JONCTION P-I-N LATERALE**
OPTOELEKTRONISCHE VORRICHTUNG MIT EINER III-V-HALBLEITERMEMBRAN-LASERQUELLE, DIE EINEN LATERALEN P-I-N ÜBERGANG BILDET
OPTOELECTRONIC DEVICE COMPRISING A LASER SOURCE WITH A III-V SEMICONDUCTOR MEMBRANE FORMING A LATERAL P-I-N JUNCTION

(30) Priorité: 29.03.2022 FR 2202792
(43) Date de publication de la demande: 04.10.2023
(73) Titulaire: Commissariat à l'énergie atomique et aux énergies alternatives, 75015 Paris (FR)
(72) Inventeur: CHOBE, Mattéo, 38054 GRENOBLE cedex 09 (FR); HASSAN, Karim, 38054 GRENOBLE Cedex 09 (FR); DUPRE, Cécilia, 38054 GRENOBLE cedex 09 (FR)
(74) Mandataire: INNOV-GROUP

(56) Documents cités:
- US-A1- 2019 131 772
- US-A1- 2019 214 789
- YINGTAO HU ET AL: "III/V-on-Si MQW lasers by using a novel photonic integration method of regrowth on a bonding template", LIGHT: SCIENCE & APPLICATIONS, vol. 8, no. 1, 9 octobre 2019 (2019-10-09) , XP055736179, DOI: 10.1038/s41377-019-0202-6

## Description

### DOMAINE TECHNIQUE

Le domaine de l'invention est celui des dispositifs optoélectroniques comportant une source laser à membrane semiconductrice III-V formant une jonction p-i-n latérale.

### ÉTAT DE LA TECHNIQUE ANTÉRIEURE

D'une manière générale, un dispositif optoélectronique tel qu'une puce photonique peut comporter une source laser couplée optiquement à un circuit photonique intégré. La source laser est réalisée à base d'un composé semiconducteur, par exemple un composé III-V tel que de l'InP, et le circuit photonique intégré est réalisé à partir d'un substrat support de type silicium sur isolant (SOI pour *Silicon On Insulator,* en anglais). Le circuit photonique intégré comporte des composants optiques passifs (guides d'onde, multiplexeurs, coupleurs...) et/ou actifs (modulateurs, photodétecteurs...), dont un guide d'onde intégré couplé optiquement à la source laser.

Ainsi, la source laser comporte un plot semiconducteur réalisé à base du composé III-V, qui forme un guide d'onde dit actif où se situe le milieu à gain. La source laser est dite hybride lorsque le mode optique dans la cavité optique est distribué dans le guide d'onde III-V et dans le guide d'onde intégré sous-jacent. Ainsi, dans le cas d'un laser de type à réflecteur de Bragg distribué (DBR, pour *Distributed Bragg Reflector,* en anglais), la cavité optique est délimitée par deux réseaux de Bragg situés dans le guide d'onde intégré, qui forment des miroirs sélectifs en longueur d'onde. Dans le cas d'un laser de type à rétroaction distribuée (DFB pour *Distributed FeedBack,* en anglais), un même réseau de Bragg est situé dans le guide d'onde intégré et s'étend sur toute la longueur de la cavité optique.

Le document US20190131772A1 divulgue un dispositif électro-optique à injection latérale de courant (LCI, mis pour *Lateral Current Injection,* en anglais), qui est compris dans ou qui est réalisé sous la forme d'une puce photonique au silicium. Le dispositif comprend une région active avec un empilement de matériaux semiconducteurs III-V empilés le long d'une direction d'empilement z. La région active peut être formée comme une dalle ayant plusieurs parties de surface latérale, chacune s'étendant parallèlement à la direction d'empilage z. Le dispositif comprend en outre deux éléments appariés, qui comprennent une paire de couches dopées de matériaux semi-conducteurs III-V (une couche dopée n et une couche dopée p) ainsi qu'une paire de noyaux de guides d'ondes latéraux. Les deux éléments appariés peuvent être disposés latéralement, deux par deux, sur les côtés opposés de la dalle. Les éléments jouxtent distinctement les parties respectives des surfaces latérales de la dalle, de manière que ces éléments soient séparés les uns des autres par la dalle.

Le document US20190214789A1 divulgue la réalisation de dispositifs optiques à puits quantiques intégrés, et concerne plus particulièrement le guidage et le confinement de modes électromagnétiques dans des matériaux à faible indice, à savoir des matériaux III-V à base de nitrure de silicium (SiN), pour des applications en bande télécom optique.

L'article de Yingtao HU et al. dans la revue "Light: Science & Applications" (2019) Vol.8, No.1, 9 octobre 2019, Official journal of the CIOMP 2047-7538, et intitulé « *III-V-on-Si MQW lasers by using a novel photonic intégration method of regrowth on a bonding template* » divulgue une méthode d'intégration photonique de reprise de croissance épitaxiale d'un matériau III-V, sur un modèle de collage de III-V sur SOI, pour réaliser des lasers hétérogènes sur silicium, et en particulier une structure de diode laser p-i-n verticale à puits quantiques multiples.

L'article de Aihara et al. intitulé Membrane buried-heterostructure DFB laser with an optically coupled III-V/Si waveguide, Opt. Express, 27(25), 36438-36448 (2019), décrit un exemple d'un dispositif optoélectronique comportant une source laser de type DFB réalisée à base d'InP, reposant sur un substrat support de type SOI et couplée à un guide d'onde en silicium d'un circuit photonique intégré. Le plot semiconducteur se présente sous la forme d'une membrane, dans la mesure où son épaisseur, de l'ordre de quelques centaines de nanomètres, est bien inférieure à ses dimensions de largeur et de longueur. De plus, le plot semiconducteur (ici la membrane semiconductrice) est formé de deux portions latérales réalisées en InP et dopées de type n et de type p, et une portion centrale comportant des puits quantiques multiples et qui forme la zone active de la source laser (émission de lumière). Les portions latérales sont agencées de part et d'autre de la portion centrale dans un plan parallèle au plan du substrat support, de manière à former une jonction p-i-n latérale pour laquelle l'injection des porteurs de charge dans la portion centrale se fait de manière latérale et non pas verticale. Enfin, les puits quantiques forment une hétérostructure dite enterrée (BH, pour *Buried-Heterostructure,* en anglais) dans la mesure où elle est située, d'une part entre deux couches en InP suivant l'axe d'épaisseur, et d'autre part entre les deux portions latérales dopées en InP suivant l'axe de la largeur. L'InP des portions latérales présente un indice de réfraction faible et une énergie de bande interdite élevée par rapport à la portion centrale, ce qui assure un confinement optique du mode guidé ainsi qu'un confinement des porteurs de charge dans la portion centrale, et réduit l'absorption des électrons dans la portion latérale d'InP dopé de type p. Enfin, la membrane semiconductrice est entourée d'un oxyde de silicium qui participe au confinement optique du mode guidé.

Il existe toutefois un besoin de disposer d'un tel dispositif optoélectronique présentant des performances améliorées.

### EXPOSÉ DE L'INVENTION

L'invention a pour objectif de remédier au moins en partie aux inconvénients de l'art antérieur, et plus particulièrement de proposer un dispositif optoélectronique comportant une source laser à membrane semiconductrice III-V formant une jonction p-i-n latérale, présentant des performances améliorées.

Pour cela, l'objet de l'invention est un dispositif optoélectronique comportant un substrat support contenant une première couche diélectrique, réalisée en un matériau électriquement isolant, et formant une face supérieure du substrat support s'étendant suivant un plan principal. Le dispositif optoélectronique comporte également une source laser comportant : une membrane semiconductrice, reposant sur la première couche diélectrique, formée d'une portion latérale dopée de type n, une portion latérale dopée de type p, et une portion centrale optiquement active située entre et au contact des portions latérales dopées pour former une jonction latérale p-i-n s'étendant parallèlement au plan principal ; une deuxième couche diélectrique, réalisée en un matériau électriquement isolant, recouvrant la membrane semiconductrice ; et des électrodes, reposant sur les portions latérales dopées, assurant ainsi une injection latérale de porteurs de charge dans la portion centrale.

Selon l'invention, la membrane semiconductrice est réalisée à base de GaAs cristallin, la portion centrale comportant des boîtes quantiques à base de GaAs, et les portions latérales dopées étant réalisées à base de AlₓGa₁₋ₓAs avec une proportion d'aluminium x comprise entre 0.05 et 0.30.

Certains aspects préférés mais non limitatifs de ce dispositif optoélectronique sont les suivants.

La proportion d'aluminium x peut être comprise entre 0.10 et 0.25.

Les électrodes peuvent être au contact des portions latérales dopées.

Le dispositif optoélectronique peut comporter une couche intercalaire, réalisée à base de Al_{y}GaAs cristallin avec une proportion d'aluminium y supérieure à la proportion d'aluminium x des portions latérales dopées, s'étendant entre et au contact de la première couche diélectrique d'une part et de la membrane semiconductrice d'autre part.

Les première et deuxième couches diélectriques peuvent être réalisées en un matériau présentant un indice de réfraction inférieur à celui de la portion centrale.

Le substrat support peut être de type SOI.

Le substrat support peut comporter un guide d'onde intégré couplé optiquement à un guide d'onde actif formé par la portion centrale de la membrane semiconductrice.

L'invention porte également sur un procédé de fabrication du dispositif optoélectronique selon l'une quelconque des caractéristiques précédentes. Il comporte les étapes suivantes :
a) réalisation d'un empilement semiconducteur, comportant : un substrat de croissance ; une couche d'arrêt de gravure épitaxiée à partir du substrat de croissance, et d'une couche intercalaire à base d'AlGaAs épitaxiée ;
b) report et assemblage de l'empilement semiconducteur sur le substrat support, la couche intercalaire étant orientée vers le substrat support ;
c) retrait du substrat de croissance puis de la couche d'arrêt de gravure ;
d) réalisation de la membrane semiconductrice, à partir d'au moins la couche intercalaire ;
e) réalisation de la deuxième couche diélectrique et des électrodes.

Selon une variante, lors de l'étape a), l'empilement semiconducteur peut comporter une couche à boîtes quantiques destinée à former la portion centrale, épitaxiée à partir de la couche d'arrêt de gravure, à partir de laquelle est épitaxiée la couche intercalaire. A la suite de l'étape c), une face de la couche à boîtes quantiques peut être rendue libre. L'étape d) peut comporter des opérations de : structuration de la couche à boîtes quantiques pour rendre libre une surface de la couche intercalaire et obtenir la portion centrale ; et réalisation des portions latérales dopées par épitaxie à partir de la couche intercalaire.

Selon une autre variante, lors de l'étape a), l'empilement semiconducteur peut comporter la couche intercalaire épitaxiée à partir de la couche d'arrêt de gravure. A la suite de l'étape c), une face de la couche intercalaire peut être rendue libre. L'étape d) peut comporter des opérations de : réalisation d'une couche à boîtes quantiques par épitaxie à partir de la couche intercalaire ; structuration de la couche à boîtes quantiques pour rendre libre une surface de la couche intercalaire et obtenir la portion centrale ; et réalisation des portions latérales dopées par épitaxie à partir de la couche intercalaire.

Selon une autre variante, le procédé peut comporter les étapes suivantes :
a) réalisation d'un empilement semiconducteur, comportant un substrat de croissance, une couche d'arrêt de gravure épitaxiée à partir du substrat de croissance, et une structure latérale épitaxiée à partir de la couche d'arrêt de gravure et formée de la portion centrale et de couches latérales dopées réalisées à base d'AlₓGa₁₋ₓAs situées de part et d'autre de la portion centrale dans le plan principal ;
b) report et assemblage de l'empilement semiconducteur sur le substrat support, la couche intercalaire étant orientée vers le substrat support ;
c) retrait du substrat de croissance puis de la couche d'arrêt de gravure, rendant libre une face de la structure latérale opposée au substrat support ;
d) réalisation de la membrane semiconductrice, par structuration des couches latérales dopées pour obtenir les portions latérales dopées ;
e) réalisation de la deuxième couche diélectrique et des électrodes.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A et 1B sont des vues schématiques et partielles, en coupe transversale (fig.1A) et en vue de dessus (fig.1B), d'un dispositif optoélectronique comportant une source laser à membrane semiconductrice, selon un mode de réalisation ;
la figure 2A illustre un exemple d'évolution du facteur de confinement optique dans la portion centrale (active) de la membrane semiconductrice en fonction de la proportion d'aluminium x dans les portions latérales dopées en AlₓGa₁₋ₓAs ;
la figure 2B illustre un exemple d'évolution de la tension de diffusion à l'interface entre la portion centrale (active) de la membrane semiconductrice et les portions latérales en AlₓGa₁₋ₓAs dopé, en fonction de la proportion d'aluminium x ;
les figures 3A à 3H illustrent des étapes d'un procédé de fabrication d'un dispositif optoélectronique, selon un mode de réalisation où la couche à boîtes quantiques est réalisée avant le report et l'assemblage sur le substrat support photonique ;
les figures 4A à 4F illustrent des étapes d'un procédé de fabrication d'un dispositif optoélectronique, selon un autre mode de réalisation où la portion centrale (active) et les couches latérales dopées sont réalisées avant le report et l'assemblage sur le substrat support photonique ;
les figures 5A à 5F illustrent des étapes d'un procédé de fabrication d'un dispositif optoélectronique, selon un autre mode de réalisation où la portion centrale (active) et les couches latérales dopées sont réalisées après le report et l'assemblage sur le substrat support photonique.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

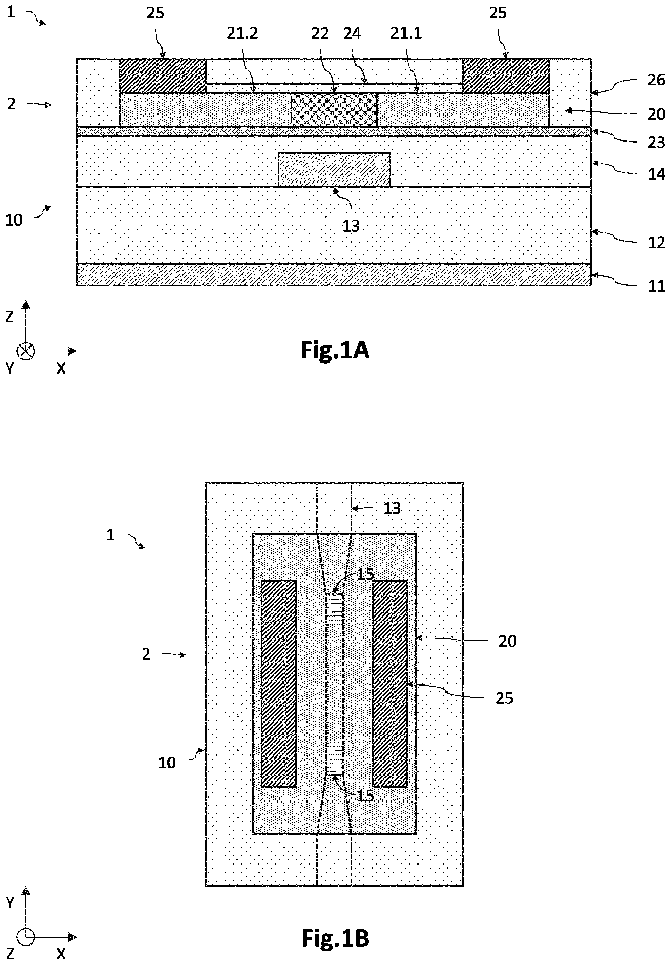

Les figures 1A et 1B sont des vues schématiques et partielles, en coupe transversale ( figure 1A) et en vue de dessus (figure 1B), d'un dispositif optoélectronique 1 selon un mode de réalisation.

D'une manière générale, le dispositif optoélectronique 1 comporte un substrat support 10, qui peut être un substrat photonique, sur lequel repose une source laser 2 à membrane semiconductrice 20. Comme indiqué précédemment, la membrane semiconductrice 20 est un plot réalisé à base d'un composé semiconducteur III-V cristallin, dont l'épaisseur est inférieure à sa largeur et à sa longueur. Elle comporte une portion centrale 22 optiquement active, située entre et au contact de deux portions latérales dopées 21.1, 21.2, ces portions 21.1, 21.2, 22 formant ensemble une jonction latérale p-i-n qui s'étend de manière parallèle à un plan principal. La portion centrale 22 (active) forme le guide d'onde actif de la source laser 2.

On définit ici et pour la suite de la description un repère direct tridimensionnel orthogonal XYZ, où les axes X et Y forment un plan parallèle à un plan principal du substrat support 10 suivant lequel il s'étend, et sont orientés respectivement suivant la largeur et la longueur de la membrane semiconductrice 20, et où l'axe Z est orienté suivant l'épaisseur de la membrane semiconductrice 20 et de manière opposée au substrat support 10.

Le substrat support 10 est ici de type SOI, et comporte dans cet exemple : un substrat 11 réalisé en silicium et présentant une épaisseur de l'ordre de plusieurs centaines de microns ; une couche 12 d'oxyde enterré (BOX, pour *Buried Oxide,* en anglais) qui recouvre le substrat 11 en silicium ; un guide d'onde intégré 13, réalisé ici en silicium monocristallin ; et une couche diélectrique d'encapsulation 14 recouvrant le guide d'onde intégré 13 et la couche 12 d'oxyde enterré. La couche diélectrique d'encapsulation 14 est réalisée en au moins un matériau électriquement isolant, qui présente également un indice de réfraction inférieur à celui du silicium d'une part, et également inférieur à celui du matériau formant le guide d'onde actif (portion centrale 22) situé dans la membrane semiconductrice 20. Il s'agit ici d'un oxyde de silicium. La couche diélectrique d'encapsulation 14 définit la face supérieure du substrat support 10.

Dans cet exemple, le substrat support 10 est un substrat photonique, dans le sens où il comporte un circuit photonique intégré (PIC) dont fait partie le guide d'onde intégré 13. Il peut donc également comporter des composants optiques actifs et/ou des composants optiques passifs, comme mentionné précédemment. En variante, le substrat support 10 peut ne pas être de type photonique, dans le sens où il ne comporte pas de circuit photonique intégré. Ainsi, le guide d'onde actif de la membrane semiconductrice 20 n'est alors pas couplé à un guide d'onde intégré 13.

La source laser 2 repose sur le substrat support 10. Elle comporte la membrane semiconductrice 20 qui est réalisée à base d'un composé semiconducteur III-V cristallin, et plus précisément à base de GaAs. Autrement dit, la membrane semiconductrice 20 comporte majoritairement du GaAs ou comporte majoritairement un ou des composés ternaires, quaternaires etc..., à base de GaAs.

La membrane semiconductrice 20 est un plot qualifié de membrane, dans la mesure où son épaisseur suivant l'axe Z est inférieure à sa largeur suivant l'axe X, et à sa longueur suivant l'axe Y. L'épaisseur peut être de l'ordre de quelques centaines de nanomètres. Dans cet exemple où le guide d'onde actif est couplé au guide d'onde intégré 13, l'épaisseur de la membrane semiconductrice 20 est choisie de manière à optimiser le couplage optique entre les deux guides d'onde. A titre d'exemple, l'épaisseur peut être comprise entre 200nm et 400nm, et être par exemple égale à 300nm environ. Par ailleurs, la largeur peut être de l'ordre de 6µm et la longueur être de l'ordre de 100µm.

On notera également que l'épaisseur est inférieure à l'épaisseur critique à partir de laquelle les contraintes mécaniques, générées lors de la réalisation par épitaxie de la membrane semiconductrice 20, relaxent de manière plastique. Ainsi, la membrane semiconductrice 20 comporte pas ou peu de défauts structuraux tels que des dislocations de désaccord de maille, et présente donc une qualité cristalline importante. Ainsi, les portions latérales 21.1, 21.2 peuvent être réalisées à base de AlₓGa₁₋ₓAs monocristallin.

La membrane semiconductrice 20 comporte donc une portion latérale 21.1 dopée de type n, une portion latérale 21.2 dopée de type p, et une portion centrale 22 dite active située entre et au contact des deux portions latérales 21.1, 21.2. Ces portions latérales 21.1, 21.2 et centrale 22 sont agencées de manière parallèle au plan principal XY, et forment ainsi une jonction p-i-n latérale et non pas verticale.

Les portions latérales 21.1, 21.2 sont réalisées à base de AlₓGa₁₋ₓAs cristallin, et ici en AlₓGa₁₋ₓAs, où x est la proportion d'aluminium. Elles sont de préférence réalisées en le même composé semiconducteur III-V, notamment en termes de proportion d'aluminium x. La portion latérale 21.1 dopée de type n peut présenter un niveau de dopage compris entre 5×10¹⁷ à 5×10¹⁸ cm⁻³ environ, et la portion latérale 21.2 dopée de type p peut présenter un niveau de dopage compris entre 5×10¹⁸ à 5×10¹⁹ cm⁻³ environ.

Comme détaillé plus loin, la proportion d'aluminium x des portions latérales dopées 21.1, 21.2 est comprise entre 0.05 et 0.30 environ, et de préférence entre 0.10 et 0.25 environ, ce qui permet d'optimiser à la fois le confinement optique du mode guidé dans le guide d'onde actif, ainsi que le confinement des porteurs de charge dans la portion centrale 22. En effet, le composé AlₓGa₁₋ₓAs présente un indice de réfraction inférieur à celui de la portion centrale 22, ainsi qu'une énergie de bande interdite (gap) supérieure à celle de la portion centrale 22. De plus, le composé AlₓGa₁₋ₓAs peut présenter une tension de diffusion ΔV_{d} réduite, pour ainsi limiter les risques de fuite des électrons de la portion centrale 22 vers la portion latérale dopée p.

La portion centrale 22 comporte des boîtes quantiques (*quantum dots,* en anglais), et non pas un empilement de puits quantiques multiples. Les boîtes quantiques sont des nanocristaux semiconducteurs dont le confinement quantique est tridimensionnel. Ils peuvent être ici de type InAs/GaAs, c'est-à-dire qu'ils sont des nanocristaux d'InAs disposés dans une couche de mouillage enGaAs. Il peut ainsi y avoir un empilement de plusieurs couches de mouillage en GaAs, chacune comportant plusieurs nanocristaux d'InAs. La taille moyenne des boîtes quantiques peut être comprise entre 0.2nm et 50nm, par exemple entre 1nm et 30nm. Par ailleurs, la portion centrale 22 est réalisée en un matériau intrinsèque, dans le sens où il n'est pas intentionnellement dopé.

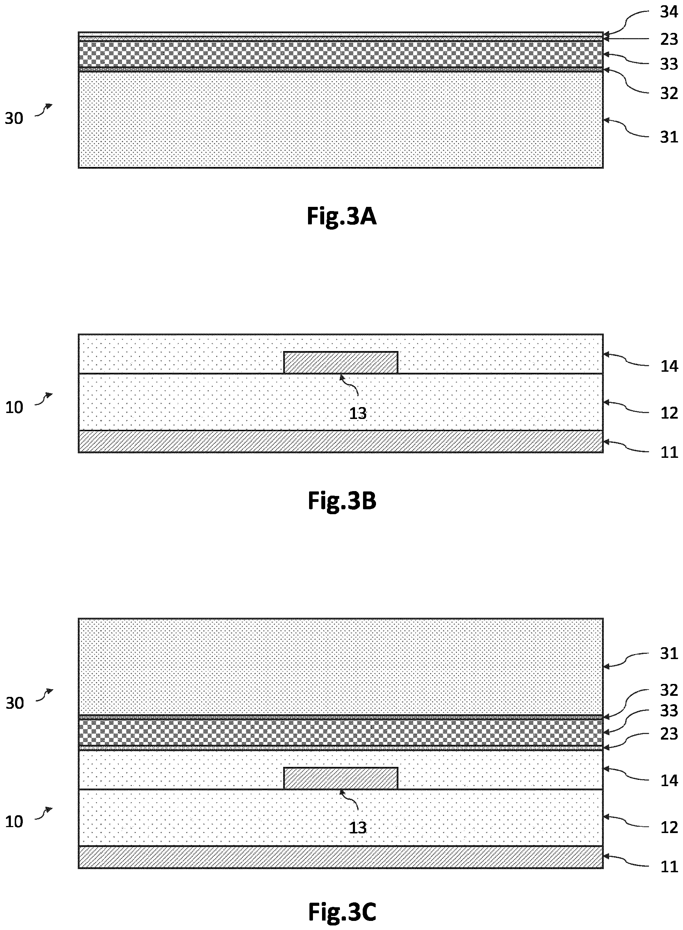

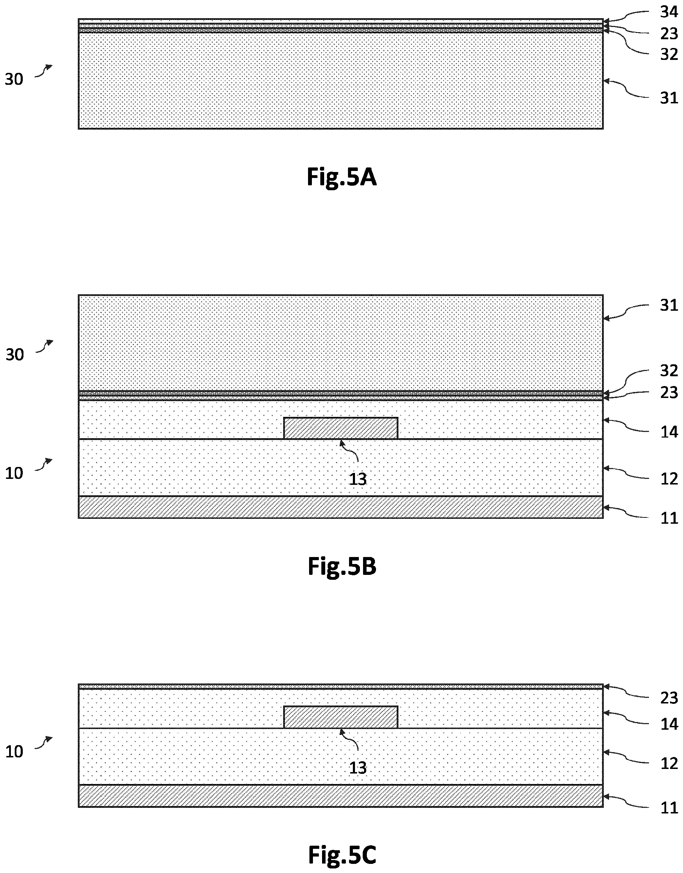

La source laser 2 comporte une couche intercalaire 23, sur laquelle repose la membrane semiconductrice 20, tout en étant au contact avec elle. La couche intercalaire 23 s'étend sur le substrat support 10, et peut recouvrir la face supérieure de celui-ci. La couche intercalaire 23 est réalisée à base d'Al_{y}Ga_{1-y}As, et est ici réalisée en Al_{y}Ga_{1-y}As. La proportion d'aluminium y est de préférence supérieure à la proportion d'aluminium x des portions latérales dopées 21.1, 21.2. Cette couche intercalaire 23 peut être présente pour permettre la croissance par épitaxie des portions latérales dopées 21.1, 21.2 lors du procédé de fabrication du dispositif optoélectronique 1 (selon les modes de réalisation des fig.3A-3H et 5A-5F). Par ailleurs, la proportion d'aluminium y étant avantageusement supérieure à x, elle présente une énergie de bande interdite supérieure à celle des portions latérales dopées 21.1, 21.2, limitant ainsi les fuites des porteurs de charge. La proportion d'aluminium x étant comprise entre 0.05 et 0.30 environ, et de préférence entre 0.10 et 0.25 environ, la proportion d'aluminium y peut être égale à 0.35 ou à 0.40 environ.

La source laser 2 comporte des électrodes 25, adaptées à appliquer une polarisation électrique à la jonction latérale p-i-n de la membrane semiconductrice 20. Ces électrodes 25 sont réalisées en un matériau électriquement conducteur, par exemple un matériau métallique, et reposent de préférence sur et au contact des portions latérales dopées 21.1, 21.2. En effet, dans la mesure où les portions latérales dopées 21.1, 21.2 sont réalisées à base d'AlGaAs, on obtient un contact ohmique performant. Notons que chaque portion latérale 21.1, 21.2 peut présenter localement, au niveau de sa face supérieure, un niveau de dopage plus élevé que le niveau de dopage sous-jacent (ou que le niveau de dopage moyen dans la portion latérale), de manière à améliorer encore la qualité du contact électrique avec l'électrode 25.

La source laser 2 peut comporter une couche diélectrique 24, située sur et au contact de la membrane semiconductrice 20 et s'étendant entre les électrodes 25 dans le plan XY. La couche diélectrique 24 s'étend plus précisément sur et au contact de la portion centrale 22 ainsi que sur des parties des portions latérales dopées 21.1, 21.2. Cette couche diélectrique 24 est réalisée en un matériau électriquement isolant, par exemple en un nitrure tel qu'un nitrure de silicium et/ou un oxyde. Il forme un masque de croissance utilisé lors du procédé de fabrication du dispositif optoélectronique 1, et plus précisément lors des étapes de réalisation des portions latérales dopées 21.1, 21.2 par croissance épitaxiale, pour éviter ainsi la croissance du composé AlₓGa₁₋ₓAs à partir de la membrane semiconductrice 20 en cours d'obtention.

La source laser 2 comporte une couche diélectrique d'encapsulation 26, qui recouvre la membrane semiconductrice 20 ainsi que le substrat support 10. Cette couche diélectrique 26 est réalisée en un matériau électriquement isolant, et présente un indice de réfraction inférieur à celui de la membrane semiconductrice 20, pour ainsi favoriser le confinement optique du mode guidé dans le guide d'onde actif. Ce matériau peut être un oxyde, par exemple un oxyde de silicium tel que du SiO₂.

Enfin, la source laser 2 est ici une source hybride de type DBR dans le sens où les réflecteurs délimitant la cavité optique sont des réseaux de Bragg 15 réalisés dans le guide d'onde intégré 13 et distants l'un de l'autre suivant l'axe Y de la longueur. Il est bien entendu possible qu'elle soit de type DFB, où un même réseau de Bragg est situé dans le guide d'onde intégré 13 et s'étend sur toute la longueur de la cavité optique. En variante, la source laser 2 peut ne pas être hydride, dans le sens où les réflecteurs sont situés, non pas dans le guide d'onde intégré 13, mais au niveau de la membrane semiconductrice 20, par exemple dans la face supérieure de la portion centrale 22 ou dans la face supérieure de la couche diélectrique.

Ainsi, le dispositif optoélectronique 1 présente des performances améliorées par rapport à celles de l'exemple de l'art antérieur mentionné précédemment, par le fait que la membrane semiconductrice 20 est réalisée à base de GaAs, qu'elle comporte des boîtes quantiques à base de GaAs, ici en InAs/GaAs, et que les portions latérales dopées 21.1, 21.2 sont réalisées à base de AlₓGa₁₋ₓAs avec une proportion d'aluminium x comprise entre 0.05 et 0.30 environ, et de préférence comprise entre 0.10 et 0.25 environ. En effet, le dispositif optoélectronique 1 présente à la fois un bon confinement optique du mode guidé dans le guide d'onde actif, mais également de bonnes propriétés électriques, tant en termes de résistance électrique dans les portions latérales (injection latérale des porteurs de charge) que de fuites des porteurs de charge hors de la portion centrale 22. De plus, il est alors possible d'obtenir une portion centrale 22 comportant des boîtes quantiques, et non pas des puits quantiques multiples, ce qui permet d'obtenir notamment une température de fonctionnement plus élevée, une réduction du courant de seuil, ainsi qu'une sensibilité réduite aux défauts cristallins, entre autres avantages des boîtes quantiques.

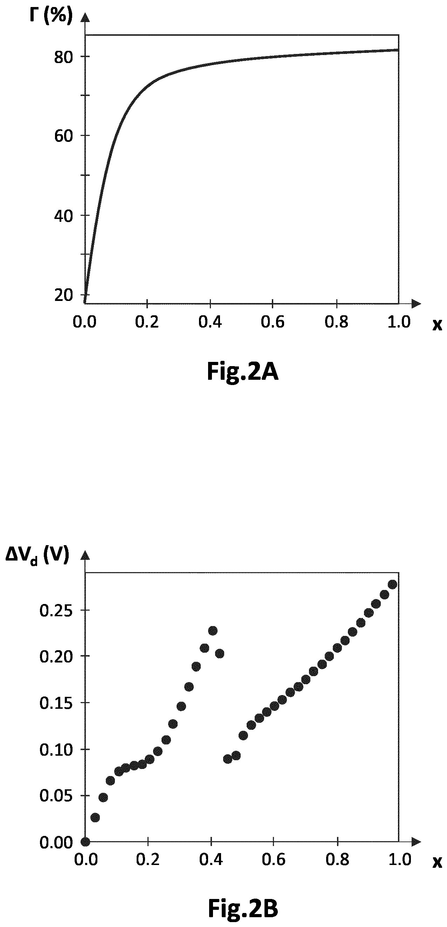

A ce titre, la figure 2A illustre un exemple d'évolution du facteur de confinement optique ┌ du mode guidé dans le guide d'onde actif (portion centrale 22), en fonction de la proportion d'aluminium x des portions latérales en AlₓGa₁₋ₓAs.

Dans cet exemple, le dispositif optoélectronique 1 comporte une membrane semiconductrice 20 de 300nm d'épaisseur comportant des portions latérales en AlₓGa₁₋ₓAs et une portion centrale 22 en GaAs intrinsèque de 1µm de largeur, encapsulée dans une couche diélectrique en SiO₂. Le guide d'onde intégré 13 n'est pas présent. Le facteur de confinement optique ┌ est déterminé par le logiciel Lumerical de simulation numérique des équations de l'électromagnétisme par le solveur de modes MODE-FDE.

Comme la courbe le montre, le facteur de confinement optique ┌ augmente très fortement entre x=0 et 0.10, puis augmente faiblement à partir de x=0.30. Il est égal ainsi à une valeur de 50% environ pour x=0.05, et à une valeur de 60% environ pour x=0.10, pour être égal à 75% environ pour x=0.30. Ainsi, une proportion d'aluminium d'au moins 0.05 environ, et de préférence d'au moins 0.10 environ, permet d'obtenir un bon confinement optique du mode guidé dans la portion centrale 22.

Par ailleurs, il apparaît que la mobilité des électrons dans les portions latérales 21.1, 21.2 d'AlₓGa₁₋ₓAs dopé, qui est représentative de la résistance électrique dans ces portions latérales 21.1, 21.2, chute fortement à mesure qu'augmente la proportion d'aluminium x. Ainsi, elle est maximale pour une proportion x nulle, et diminue de quasiment deux ordres de grandeur lorsque la proportion x est de l'ordre de 0.40 à 0.50. Ainsi, il apparaît que la mobilité des électrons, et donc la résistance électrique, reste suffisamment élevée pour une proportion d'aluminium x d'au plus 0.30 environ, et de préférence d'au plus 0.25 environ, pour que la source laser 2 présente de bonnes propriétés électriques.

Enfin, la figure 2B illustre un exemple d'évolution de la tension de diffusion ΔV_{d} associée aux barrières de potentiel à l'interface entre la portion centrale 22 et les portions latérales dopées 21.1, 21.2, en fonction de la proportion d'aluminium x des portions latérales en AlₓGa₁₋ₓAs.

La configuration du dispositif optoélectronique 1 est ici similaire à celle de la figure 2A. La tension de diffusion ΔV_{d} est déterminée par le logiciel de simulation SILVACO^{®} d'ATLAS^{®}. La courbe montre que la tension de diffusion ΔV_{d} augmente jusqu'à x=0.40 avant de diminuer fortement. En effet, à partir de 0.40 environ, la structure de bandes d'énergie de l'AlₓGa₁₋ₓAs passe d'une structure directe à une structure indirecte. Il importe toutefois que la proportion d'aluminium reste faible, ici inférieure à 0.30 environ pour que la tension de diffusion soit faible également. Ainsi, il n'est pas nécessaire d'appliquer une différence de potentiels importante aux portions latérales dopées de la source laser, ce qui permet de limiter les risques de fuite des électrons de la portion centrale 22 vers la portion latérale dopée p.

Aussi, par le fait que les portions latérales soient réalisées à base d'AlₓGa₁₋ₓAs avec une proportion d'aluminium comprise entre 0.05 et 0.30 environ, et de préférence entre 0.10 et 0.25 environ, le dispositif optoélectronique 1 présente des performances optimisées en termes de propriétés optiques (confinement optique dans la portion centrale 22) et de propriétés électriques (confinement et réduction des fuites des porteurs de charge).

Les figures 3A à 3H illustrent des étapes d'un procédé de fabrication d'un dispositif optoélectronique 1 similaire à celui des fig.1A et 1B, selon un premier mode de réalisation.

En référence à la figure 3A, on réalise tout d'abord un empilement semiconducteur 30, comportant, suivant un axe vertical : un substrat de croissance 31 à base de GaAs, par exemple ici réalisé en GaAs; une couche d'arrêt de gravure 32 ; une couche 33 comportant les boîtes quantiques ici de type InAs/GaAs; et enfin la couche intercalaire 23 à base d'Al_{y}Ga_{1-y}As. L'empilement semiconducteur 30 peut également être recouvert par une couche de collage 34, ici à base d'un oxyde tel que du SiO₂.

Le substrat de croissance 31 est ici réalisé en GaAs cristallin, et de préférence monocristallin. Il peut être réalisé en un autre matériau cristallin, qui présenterait un paramètre de maille adapté à la croissance épitaxiale de la couche d'arrêt de gravure 32 et ensuite de la couche 33 à boîtes quantiques.

La couche d'arrêt de gravure 32 est réalisée par épitaxie d'un matériau semiconducteur cristallin à partir du substrat de croissance 31. Elle peut ici être réalisée en ln_{0.49}Ga_{0.51}P, qui présente un bon accord du paramètre de maille avec celui du GaAs du substrat de croissance 31. Elle peut présenter une épaisseur de l'ordre de 200nm.

La couche 33 à boîtes quantiques est réalisée par épitaxie à partir de la couche d'arrêt de gravure 32, de manière à former des boîtes quantiques de type InAs/GaAs ou équivalents. Il s'agit donc de nanocristaux d'InAs situés dans des couches de mouillage en GaAs. La couche 33 à boîtes quantiques peut être réalisée par la méthode de croissance de Stranski-Krastanow. Elle consiste à déposer un matériau (ici de l'InAs) présentant un désaccord de maille avec le GaAs. La croissance est tout d'abord bidimensionnelle (couche pseudomorphique d'InAs) jusqu'à atteindre une épaisseur critique où la relaxation des contraintes mécaniques conduit à la formation des boîtes quantiques. Cette méthode, bien connue, n'est pas davantage détaillée. La couche 33 à boîtes quantiques présente l'épaisseur souhaitée de la membrane semiconductrice 20, par exemple de l'ordre de quelques centaines de nanomètres. On peut avoir plusieurs plans superposés de boîtes quantiques.

La couche de collage 34, ici réalisée en SiO₂, peut être amincie par polissage mécanochimique (CMP) de sorte qu'elle présente une épaisseur de l'ordre de quelques dizaines de nanomètres, par exemple 50nm, ainsi qu'une rugosité RMS adaptée au collage avec le substrat support 10. Notons par ailleurs que cette couche de collage 34 reste facultative, dans la mesure où un assemblage par collage de type lll-V sur oxyde peut également être envisagé.

En référence à la figure 3B, on réalise le substrat support 10, lequel est ici un substrat photonique de type SOI. Comme indiqué précédemment, il comporte : un substrat 11 en silicium ; une couche 12 d'oxyde enterré (BOX) ; un guide d'onde intégré 13 en silicium monocristallin appartenant à un circuit photonique intégré (PIC) ; et enfin une couche diélectrique d'encapsulation 14, réalisée ici en un oxyde de silicium, qui recouvre le guide d'onde intégré 13 et la couche 12 d'oxyde enterré.

En référence à la figure 3C, on effectue le report et l'assemblage par collage de l'empilement semiconducteur 30 sur le substrat support 10, de sorte que la couche de collage 34 soit au contact de la couche diélectrique d'encapsulation 14. Dans cet exemple, l'assemblage est effectué par collage direct de type oxyde/oxyde.

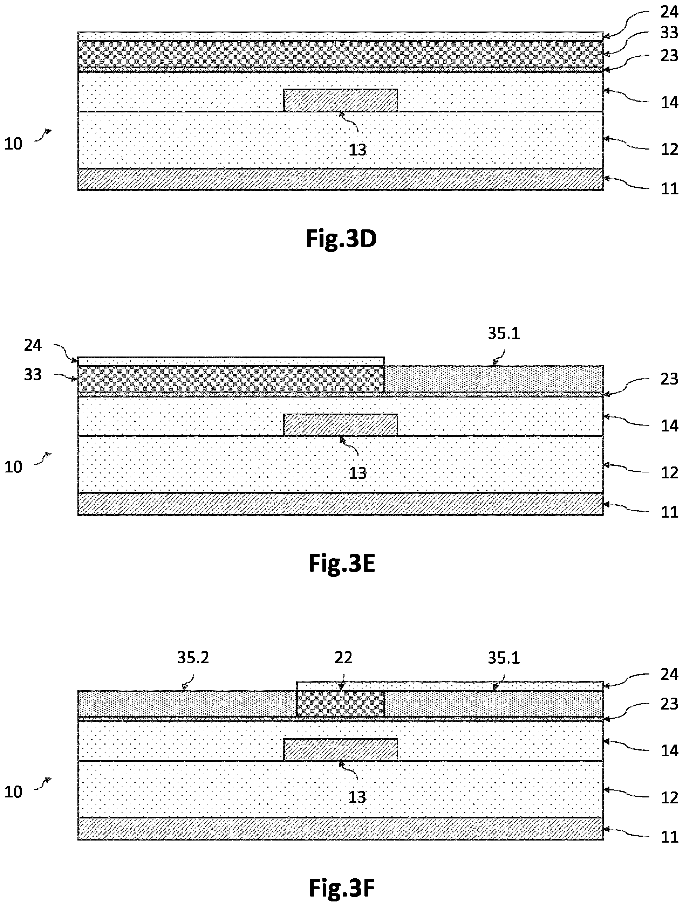

En référence à la figure 3D, on retire le substrat de croissance 31, par exemple par amincissement mécanique (*grinding,* en anglais) suivi d'une gravure chimique du GaAs sélective au matériau de la couche d'arrêt de gravure 32 en InGaP. On supprime ensuite la couche d'arrêt de gravure 32, par exemple par gravure chimique sélective au matériau de la couche 33 à boîtes quantiques. Enfin, on dépose une couche diélectrique 24 de manière à recouvrir la couche 33 à boîtes quantiques, cette couche diélectrique 24 formant un masque dur pour la réalisation des portions latérales dopées 21.1, 21.2. Elle peut être réalisée en au moins un matériau électriquement isolant, comme un oxyde ou un nitrure de silicium, voire être un bicouche formé d'une couche mince en un nitrure et d'une couche mince en un oxyde. Dans cet exemple, la couche diélectrique 24 est réalisée en un nitrure de silicium.

En référence à la figure 3E, on réalise une couche latérale dopée 35.1, par exemple ici la couche latérale dopée de type n. Elle est réalisée ici en AlₓGa₁₋ₓAs, et est destinée à former la portion latérale 21.1 dopée de type n. Pour cela, une partie de la couche diélectrique 24 est supprimée, puis la partie rendue libre de la couche 33 à boîtes quantiques est supprimée sur toute son épaisseur par photolithographie et gravure localisée. La gravure peut être une gravure plasma sélective à la couche intercalaire 23 en Al_{y}Ga_{1-y}As. Une reprise d'épitaxie est ensuite effectuée pour former une couche latérale 35.1 ici en AlₓGa₁₋ₓAs dopé de type n, qui vient en contact latéral avec la couche 33 à boîtes quantiques. Le dopage est ici effectué à la croissance mais un dopage par implantation ionique ou par diffusion est également possible. Comme indiqué précédemment, le niveau de dopage de type n peut être de l'ordre de 5×10¹⁷ à 5×10¹⁸ cm⁻³.

En référence à la figure 3F, on réalise ensuite la couche latérale 35.2 dopée de type p, réalisée ici en AlₓGa₁₋ₓAs destinée à former la portion latérale 21.2 dopée de type p. Pour cela, une partie de la couche diélectrique 24 est supprimée, puis la partie rendue libre de la couche 33 à boîtes quantiques est supprimée sur toute son épaisseur par photolithographie et gravure localisée. La partie restant de la couche 33 à boîtes quantiques forme alors la portion centrale 22 (active). Une reprise d'épitaxie est ensuite effectuée pour former une couche latérale 35.2 ici en AlₓGa₁₋ₓAs dopé de type p, qui vient en contact latéral avec la portion centrale 22. Le niveau de dopage de type p peut être de l'ordre de 5x10¹⁸ à 5×10¹⁹ cm⁻³.

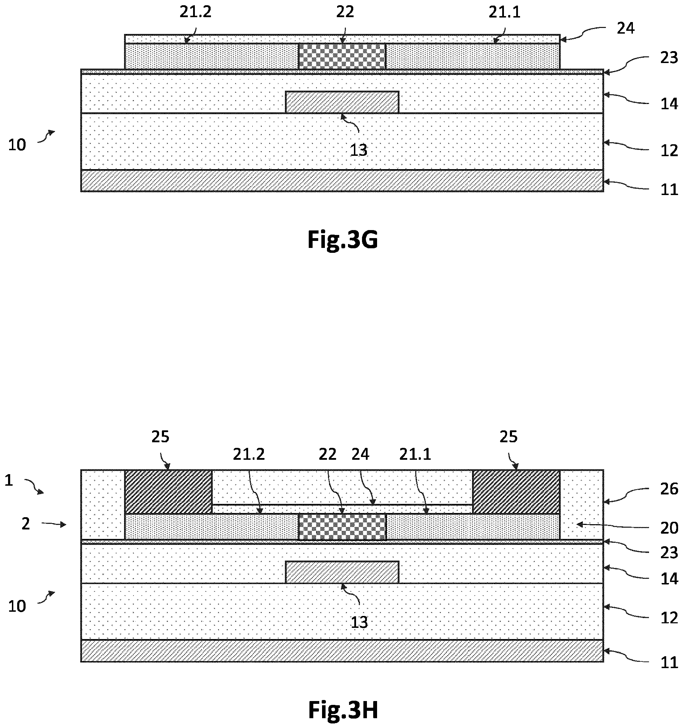

En référence à la figure 3G, on réalise ensuite les portions latérales dopées 21.1, 21.2, par photolithographie et gravure localisée de la couche diélectrique 24 puis d'une partie des couches latérales dopées 35.1, 35.2 sur toute leur épaisseur. La gravure peut être sélective à la couche intercalaire 23 comme ici, ou peut s'arrêter sur l'oxyde de la couche diélectrique d'encapsulation 14. On obtient ainsi la membrane semiconductrice 20, formée de la portion centrale 22 située entre et au contact des portions latérales dopées 21.1, 21.2, formant ainsi une jonction latérale p-i-n. La membrane semiconductrice 20 est revêtue ici de la couche diélectrique 24.

En référence à la figure 3H, on dépose la couche diélectrique d'encapsulation 26, réalisée par exemple en un oxyde tel que du SiO₂, de manière à recouvrir la membrane semiconductrice 20 et le substrat support 10. Des électrodes 25 sont ensuite réalisées au travers de la couche diélectrique d'encapsulation 26, qui viennent ici au contact des portions latérales dopées 21.1, 21.2.

On obtient ainsi un dispositif optoélectronique 1, comportant une source laser 2 à membrane semiconductrice 20, enterrée dans un matériau diélectrique (couches 14 et 26), qui présente des performances optiques et électriques améliorées.

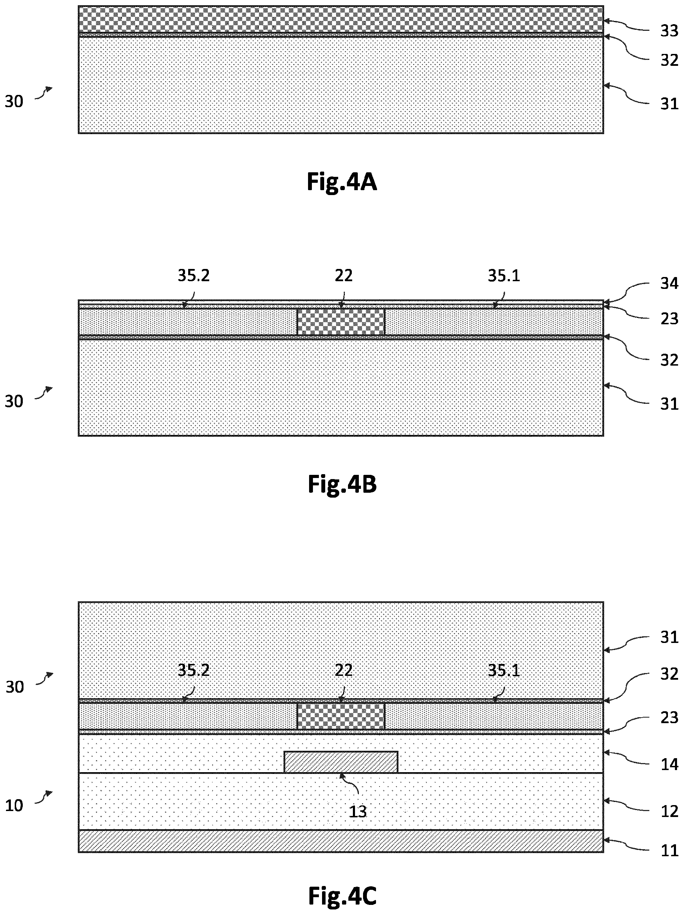

Les figures 4A à 4F illustrent des étapes d'un procédé de fabrication d'un dispositif optoélectronique 1 similaire à celui des figures 1A et 1B, selon un deuxième mode de réalisation. Ici, la portion centrale 22 et les couches latérales 35.1, 35.2 sont réalisées dans l'empilement semiconducteur 30, et non pas sur le substrat support 10. Cela permet notamment d'éviter que la montée en température lors de la réalisation par épitaxie des couches latérales 35.1, 35.2 ne vienne dégrader la qualité du collage direct. On notera que dans ce mode de réalisation, la couche intercalaire 23 à base d'Al_{y}Ga_{1-y}As est facultative, dans la mesure où les couches latérales 35.1, 35.2 ne sont pas épitaxiées à partir de cette couche intercalaire 23, mais le sont à partir de la couche d'arrêt de gravure avant l'étape de report et de collage.

En référence à la figure 4A, on réalise tout d'abord un empilement semiconducteur 30, comportant le substrat de croissance 31 ici en GaAs, la couche d'arrêt de gravure 32 ici en InGaP, et la couche 33 à boîtes quantiques.

En référence à la figure 4B, on réalise ensuite la portion centrale 22 et les couches latérales 35.1, 35.2, par photolithographie et gravure localisée de la couche 33 à boîtes quantiques sur toute son épaisseur, puis par reprise d'épitaxie à partir de la couche d'arrêt de gravure 32. Les couches latérales 35.1, 35.2 ont de préférence été dopées à la croissance. Cette étape est effectuée de manière similaire aux étapes des fig. 3D à 3F décrites précédemment. On réalise ensuite la couche intercalaire 23 en Al_{y}Ga_{1-y}As, par épitaxie à partir de la portion centrale 22 et des couches latérales, puis on dépose ensuite la couche de collage 34 en SiO₂. Comme indiqué précédemment, la couche intercalaire 23 est facultative mais avantageuse.

En référence à la figure 4C, on effectue le report et l'assemblage par collage de l'empilement semiconducteur 30 sur le substrat support 10, de sorte que la couche de collage 34 soit au contact de la couche diélectrique d'encapsulation 14. Dans cet exemple, l'assemblage est effectué par collage direct de type oxyde/oxyde, mais, comme indiqué précédemment, un collage III-V/SiO₂ est possible.

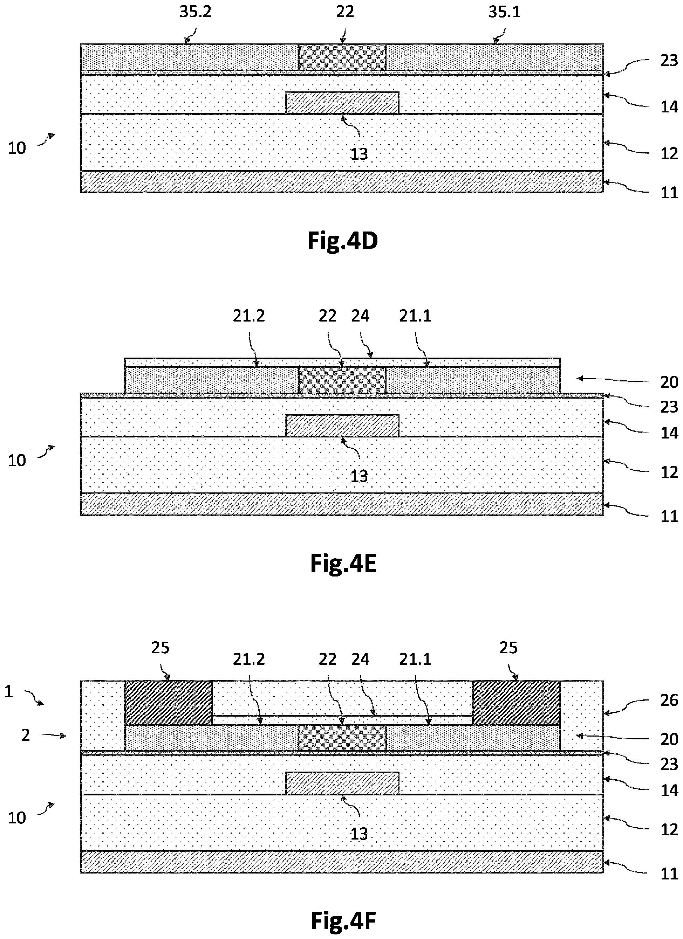

En référence à la figure 4D, on retire le substrat de croissance 31, puis on supprime la couche d'arrêt de gravure 32. Cette étape est effectuée comme précédemment et n'est pas détaillée à nouveau. A la suite de cette étape, la face supérieure de la portion centrale 22 et celle des couches latérales dopées 35.1, 35.2 sont rendues libres.

En référence à la figure 4E, on réalise la membrane semiconductrice 20. Pour cela, comme décrit précédemment, on dépose la couche diélectrique 24 (masque dur) sur la portion centrale 22 et les couches latérales dopées 35.1, 35.2, et on réalise les portions latérales dopées 21.1, 21.2 par photolithographie et gravure localisée des couches latérales dopées 35.1, 35.2.

En référence à la figure 4F, on finalise la fabrication du dispositif optoélectronique 1, par la réalisation de la couche diélectrique d'encapsulation 26 recouvrant la membrane semiconductrice 20 et le substrat support 10, suivie de la réalisation des électrodes 25.

Les figures 5A à 5F illustrent des étapes d'un procédé de fabrication d'un dispositif optoélectronique 1 similaire à celui des figures 1A et 1B, selon un troisième mode de réalisation. Ici, la couche 33 à boîtes quantiques n'est pas réalisée dans l'empilement semiconducteur 30, mais sur le substrat support 10. Cela permet, à l'inverse du mode de réalisation des figures 4A à 4F, de mettre à profit la montée en température lors de la réalisation par épitaxie de la couche 33 à boîtes quantiques comme des couches latérales pour venir renforcer la qualité du collage direct, et d'éviter d'éventuels défauts de topologie de surface que l'épitaxie de la couche 33 pourrait induire. On note que dans ce mode de réalisation, à la différence de celui des figures 4A à 4F, la couche intercalaire 23 est présente pour permettre la réalisation des couches latérales dopées 35.1, 35.2 par reprise d'épitaxie.

En référence à la figure 5A, on réalise tout d'abord un empilement semiconducteur 30, comportant le substrat de croissance 31 ici en GaAs, la couche d'arrêt de gravure 32 ici en InGaP, et la couche intercalaire 23 en Al_{y}Ga_{1-y}As. Ainsi, l'empilement semiconducteur 30 ne comporte pas la couche 33 à boîtes quantiques. La couche intercalaire 23 est donc réalisée par épitaxie à partir de la couche d'arrêt de gravure 32. Une couche de collage 34 en SiO₂ recouvre ensuite la couche intercalaire 23.

En référence à la figure 5B, on reporte et assemble l'empilement semiconducteur 30 sur le substrat support 10.

En référence à la figure 5C, le substrat de croissance 31 est ensuite retiré, et la couche d'arrêt de gravure 32 est supprimée. Ainsi, la couche intercalaire 23 repose sur le substrat support 10, et sa face supérieure est rendue libre.

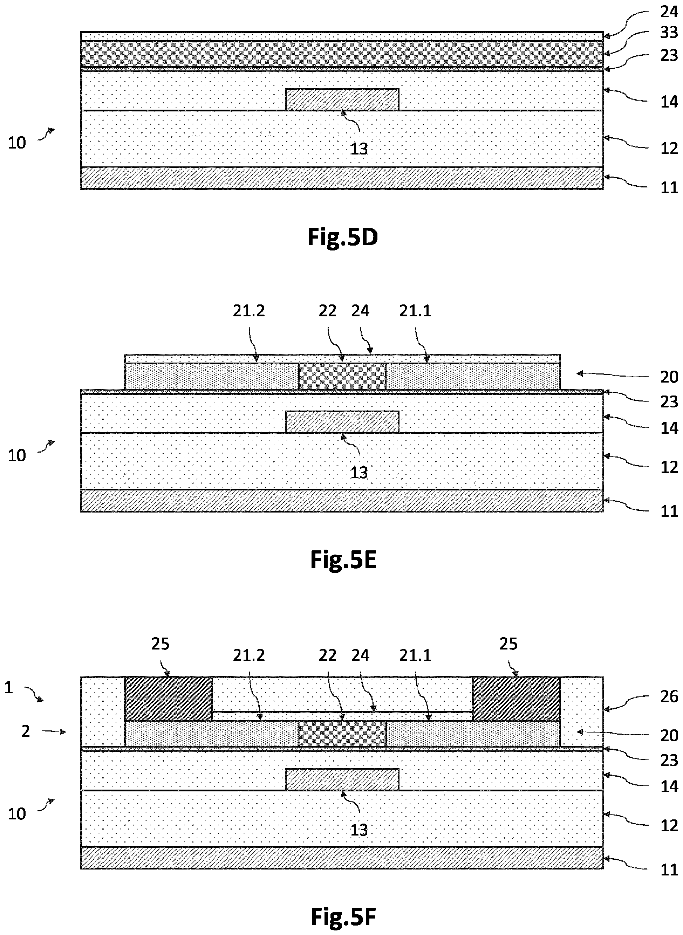

En référence à la figure 5D, on réalise la couche 33 à boîtes quantiques, par épitaxie à partir de la couche intercalaire 23. Ici, à la différence des modes de réalisation décrits précédemment, la couche 33 à boîtes quantiques est réalisée après l'étape de report et de collage direct. De plus, elle est réalisée par épitaxie à partir de la couche intercalaire 23 en Al_{y}Ga_{1-y}As et non pas à partir de la couche d'arrêt de gravure en InGaP.

En référence à la figure 5E et à la figure 5F, on réalise ensuite la membrane semiconductrice 20, de la même manière que précédemment, puis on finalise la fabrication du dispositif optoélectronique.

Des modes de réalisation particuliers viennent d'être décrits. Différentes variantes et modifications apparaîtront à l'homme du métier.

## Revendications

1. Dispositif optoélectronique (1), comportant :
∘ un substrat support (10), comportant :
• une première couche diélectrique (14), réalisée en un matériau électriquement isolant, et formant une face supérieure du substrat support (10) s'étendant suivant un plan principal ; et
∘ une source laser (2), comportant :
• une membrane semiconductrice (20), reposant sur la première couche diélectrique (14), formée d'une portion latérale (21.1) dopée de type n, une portion latérale (21.2) dopée de type p, et une portion centrale (22) optiquement active située entre et au contact des portions latérales dopées (21.1, 21.2) pour former une jonction latérale p-i-n s'étendant parallèlement au plan principal ;
• une deuxième couche diélectrique (26), réalisée en un matériau électriquement isolant, recouvrant la membrane semiconductrice (20) ; et
• des électrodes (25), reposant sur les portions latérales dopées (21.1, 21.2), assurant ainsi une injection latérale de porteurs de charge dans la portion centrale,
où la membrane semiconductrice (20) est réalisée à base de GaAs cristallin, et la portion centrale (22) comporte des boîtes quantiques à base de GaAs,
**caractérisé en ce que**
les portions latérales dopées (21.1, 21.2) sont réalisées à base de AlₓGa₁₋ₓAs avec une proportion d'aluminium x comprise entre 0.05 et 0.30.

2. Dispositif optoélectronique (1) selon la revendication 1, dans lequel la proportion d'aluminium x est comprise entre 0.10 et 0.25.

3. Dispositif optoélectronique (1) selon la revendication 1 ou 2, dans lequel les électrodes (25) sont au contact des portions latérales dopées (21.1, 21.2).

4. Dispositif optoélectronique (1) selon l'une quelconque des revendications 1 à 3, comportant une couche intercalaire (23), réalisée à base de Al_{y}GaAs cristallin avec une proportion d'aluminium y supérieure à la proportion d'aluminium x des portions latérales dopées (21.1, 21.2), s'étendant entre et au contact de la première couche diélectrique (14) d'une part et de la membrane semiconductrice (20) d'autre part.

5. Dispositif optoélectronique (1) selon l'une quelconque des revendications 1 à 4, dans lequel la première et la deuxième couches diélectriques (14, 26) sont réalisées en un matériau présentant un indice de réfraction inférieur à celui de la portion centrale (22).

6. Dispositif optoélectronique (1) selon l'une quelconque des revendications 1 à 5, dans lequel le substrat support (10) est de type SOI.

7. Dispositif optoélectronique (1) selon l'une quelconque des revendications 1 à 6, dans lequel le substrat support (10) comporte un guide d'onde intégré (13) couplé optiquement à un guide d'onde actif formé par la portion centrale (22) de la membrane semiconductrice (20).

8. Procédé de fabrication d'un dispositif optoélectronique (1) selon l'une quelconque des revendications 1 à 7, comportant les étapes suivantes :
∘ a) réalisation d'un empilement semiconducteur (30), comportant : un substrat de croissance (31) ; une couche d'arrêt de gravure (32) épitaxiée à partir du substrat de croissance (31), et d'une couche intercalaire (23) à base d'AlGaAs épitaxiée ;
∘ b) report et assemblage de l'empilement semiconducteur (30) sur le substrat support (10), la couche intercalaire (23) étant orientée vers le substrat support (10) ;
∘ c) retrait du substrat de croissance (31) puis de la couche d'arrêt de gravure (32) ;
∘ d) réalisation de la membrane semiconductrice (20), à partir d'au moins la couche intercalaire (23) ;
∘ e) réalisation de la deuxième couche diélectrique (26) et des électrodes (25).

9. Procédé de fabrication selon la revendication 8, dans lequel :
∘ lors de l'étape a), l'empilement semiconducteur (30) comporte une couche (33) à boîtes quantiques destinée à former la portion centrale (22), épitaxiée à partir de la couche d'arrêt de gravure (32), à partir de laquelle est épitaxiée la couche intercalaire (23) ;
∘ à la suite de l'étape c), une face de la couche (33) à boîtes quantiques est rendue libre ;
∘ l'étape d) comporte des opérations de : structuration de la couche (33) à boîtes quantiques pour rendre libre une surface de la couche intercalaire (23) et obtenir la portion centrale (22) ; et réalisation des portions latérales dopées (21.1, 21.2) par épitaxie à partir de la couche intercalaire (23).

10. Procédé de fabrication selon la revendication 8, dans lequel :
∘ lors de l'étape a), l'empilement semiconducteur (30) comporte la couche intercalaire (23) épitaxiée à partir de la couche d'arrêt de gravure (32) ;
∘ à la suite de l'étape c), une face de la couche intercalaire (23) est rendue libre ;
∘ l'étape d) comporte des opérations de : réalisation d'une couche (33) à boîtes quantiques par épitaxie à partir de la couche intercalaire (23) ; structuration de la couche (33) à boîtes quantiques pour rendre libre une surface de la couche intercalaire (23) et obtenir la portion centrale (22) ; et réalisation des portions latérales dopées (21.1, 21.2) par épitaxie à partir de la couche intercalaire (23).

11. Procédé de fabrication d'un dispositif optoélectronique (1) selon l'une quelconque des revendications 1 à 7, comportant les étapes suivantes :
∘ a) réalisation d'un empilement semiconducteur (30), comportant un substrat de croissance (31), une couche d'arrêt de gravure (32) épitaxiée à partir du substrat de croissance (31), et une structure latérale épitaxiée à partir de la couche d'arrêt de gravure (32) et formée de la portion centrale (22) et de couches latérales dopées (35.1, 35.2) réalisées à base d'AlₓGa₁₋ₓAs situées de part et d'autre de la portion centrale (22) dans le plan principal ;
∘ b) report et assemblage de l'empilement semiconducteur (30) sur le substrat support (10), la couche intercalaire (23) étant orientée vers le substrat support (10) ;
∘ c) retrait du substrat de croissance (31) puis de la couche d'arrêt de gravure (32), rendant libre une face de la structure latérale opposée au substrat support (10) ;
∘ d) réalisation de la membrane semiconductrice (20), par structuration des couches latérales dopées (35.1, 35.2) pour obtenir les portions latérales dopées (21.1, 21.2) ;
∘ e) réalisation de la deuxième couche diélectrique (26) et des électrodes (25).

## Patentansprüche

1. Optoelektronische Vorrichtung (1), umfassend:
∘ ein Trägersubstrat (10), umfassend:
• eine erste dielektrische Schicht (14), die aus einem elektrisch isolierenden Material ausgeführt ist und eine Oberseite des Trägersubstrats (10) bildet, die sich entlang einer Hauptebene erstreckt; und
∘ eine Laserquelle (2), umfassend:
• eine Halbleitermembran (20), die auf der ersten dielektrischen Schicht (14) aufliegt und gebildet wird aus einem n-dotierten lateralen Abschnitt (21.1), einem p-dotierten lateralen Abschnitt (21.2) und einem optisch aktiven mittleren Abschnitt (22), der zwischen und in Kontakt mit den dotierten lateralen Abschnitten (21.1, 21.2) gelegen ist, um einen lateralen p-i-n-Übergang zu bilden, der sich parallel zu der Hauptebene erstreckt;
• eine zweite dielektrische Schicht (26), die aus einem elektrisch isolierenden Material ausgeführt ist und die Halbleitermembran (20) bedeckt; und
• Elektroden (25), die auf den dotierten lateralen Abschnitten (21.1, 21.2) aufliegen und so eine laterale Injektion von Ladungsträgern in den mittleren Abschnitt gewährleisten,
wobei die Halbleitermembran (20) auf Basis von kristallinem GaAs ausgeführt ist und der mittlere Abschnitt (22) Quantenpunkte auf Basis von GaAs umfasst, **dadurch gekennzeichnet, dass** die dotierten lateralen Abschnitte (21.1, 21.2) auf Basis von AlₓGa₁₋ₓAs mit einem Aluminiumanteil x zwischen 0,05 und 0,30 ausgeführt sind.

2. Optoelektronische Vorrichtung (1) nach Anspruch 1, bei welcher der Aluminiumanteil x zwischen 0,10 und 0,25 beträgt.

3. Optoelektronische Vorrichtung (1) nach Anspruch 1 oder 2, bei der die Elektroden (25) in Kontakt mit den dotierten lateralen Abschnitten (21.1, 21.2) sind.

4. Optoelektronische Vorrichtung (1) nach einem der Ansprüche 1 bis 3, umfassend eine Zwischenschicht (23), die auf Basis von kristallinem Al_{y}GaAs mit einem Aluminiumanteil y ausgeführt ist, der größer als der Aluminiumanteil x der dotierten lateralen Abschnitte (21.1, 21.2) ist, und die sich zwischen und in Kontakt mit der ersten dielektrischen Schicht (14) auf der einen Seite und der Halbleitermembran (20) auf der anderen Seite erstreckt.

5. Optoelektronische Vorrichtung (1) nach einem der Ansprüche 1 bis 4, bei der die erste und die zweite dielektrische Schicht (14, 26) aus einem Material ausgeführt sind, das einen geringeren Brechungsindex als der mittlere Abschnitt (22) aufweist.

6. Optoelektronische Vorrichtung (1) nach einem der Ansprüche 1 bis 5, bei der das Trägersubstrat (10) vom SOI-Typ ist.

7. Optoelektronische Vorrichtung (1) nach einem der Ansprüche 1 bis 6, bei der das Trägersubstrat (10) einen integrierten Wellenleiter (13) umfasst, der optisch an einen aktiven Wellenleiter gekoppelt ist, der durch den mittleren Abschnitt (22) der Halbleitermembran (20) gebildet wird.

8. Verfahren zur Herstellung einer optoelektronischen Vorrichtung (1) nach einem der Ansprüche 1 bis 7, umfassend die folgenden Schritte:
∘ a) Ausführen eines Halbleiterstapels (30), umfassend: ein Wachstumssubstrat (31); eine Ätzstoppschicht (32), die ausgehend von dem Wachstumssubstrat (31) epitaxiert wird, und eine epitaxierte Zwischenschicht (23) auf Basis von AlGaAs-,
∘ b) Übertragen und Montieren des Halbleiterstapels (30) auf das Trägersubstrat (10), wobei die Zwischenschicht (23) zu dem Trägersubstrat (10) hin gerichtet ist;
∘ c) Entfernen des Wachstumssubstrats (31), dann der Ätzstoppschicht (32);
∘ d) Ausführen der Halbleitermembran (20) ausgehend von mindestens der Zwischenschicht (23);
∘ e) Ausführen der zweiten dielektrischen Schicht (26) und der Elektroden (25).

9. Verfahren zur Herstellung nach Anspruch 8, bei dem:
∘ beim Schritt a) der Halbleiterstapel (30) eine Quantenpunktschicht (33) umfasst, die dazu bestimmt ist, den mittleren Abschnitt (22) zu bilden, die ausgehend von der Ätzstoppschicht (32) epitaxiert wird und ausgehend von welcher die Zwischenschicht (23) epitaxiert wird;
∘ nach dem Schritt c) eine Seite der Quantenpunktschicht (33) freigelegt wird;
∘ der Schritt d) Vorgänge umfasst zum: Strukturieren der Quantenpunktschicht (33), um eine Oberfläche der Zwischenschicht (23) freizulegen und den mittleren Abschnitt (22) zu erhalten; und Ausführen der dotierten lateralen Abschnitte (21.1, 21.2) durch Epitaxie ausgehend von der Zwischenschicht (23).

10. Verfahren zur Herstellung nach Anspruch 8, bei dem:
∘ beim Schritt a) der Halbleiterstapel (30) die Zwischenschicht (23) umfasst, die ausgehend von der Ätzstoppschicht (32) epitaxiert wird;
∘ nach dem Schritt c) eine Seite der Zwischenschicht (23) freigelegt wird;
∘ der Schritt d) Vorgänge umfasst zum: Ausführen einer Quantenpunktschicht (33) durch Epitaxie ausgehend von der Zwischenschicht (23); Strukturieren der Quantenpunktschicht (33), um eine Oberfläche der Zwischenschicht (23) freizulegen und den mittleren Abschnitt (22) zu erhalten; und Ausführen der dotierten lateralen Abschnitte (21.1, 21.2) durch Epitaxie ausgehend von der Zwischenschicht (23).

11. Verfahren zur Herstellung einer optoelektronischen Vorrichtung (1) nach einem der Ansprüche 1 bis 7, umfassend die folgenden Schritte:
∘ a) Ausführen eines Halbleiterstapels (30), umfassend ein Wachstumssubstrat (31), eine Ätzstoppschicht (32), die ausgehend von dem Wachstumssubstrat (31) epitaxiert wird, und eine laterale Struktur, die ausgehend von der Ätzstoppschicht (32) epitaxiert wird und gebildet wird aus dem mittleren Abschnitt (22) und dotierten lateralen Schichten (35.1, 35.2), die auf Basis von AlₓGa₁₋ₓAs ausgeführt sind und beidseits des mittleren Abschnitts (22) in der Hauptebene gelegen sind;
∘ b) Übertragen und Montieren des Halbleiterstapels (30) auf das Trägersubstrat (10), wobei die Zwischenschicht (23) zu dem Trägersubstrat (10) hin gerichtet ist;
∘ c) Entfernen des Wachstumssubstrats (31), dann der Ätzstoppschicht (32), wodurch eine Seite der lateralen Struktur freigelegt wird, die entgegengesetzt zu dem Trägersubstrat (10) ist;
∘ d) Ausführen der Halbleitermembran (20) durch Strukturieren der dotierten lateralen Schichten (35.1, 35.2), um die dotierten lateralen Abschnitte (21.1, 21.2) zu erhalten;
∘ e) Ausführen der zweiten dielektrischen Schicht (26) und der Elektroden (25).

## Claims

1. Optoelectronic device (1), comprising:
∘ a carrier substrate (10), comprising:
• a first dielectric layer (14), which is made of an electrically insulating material, and which forms a top side of the carrier substrate (10) lying in a main plane; and
∘ a laser source (2), comprising:
• a semiconductor membrane (20), which rests on the first dielectric layer (14), and which is formed from a lateral segment (21.1) doped n-type, a lateral segment (21.2) doped p-type, and an optically active central segment (22) located between and in contact with the doped lateral segments (21.1, 21.2) to form a lateral p-i-n junction lying parallel to the main plane;
• a second dielectric layer (26), which is made of an electrically insulating material, and which covers the semiconductor membrane (20); and
• electrodes (25), which rest on the doped lateral segments (21.1, 21.2), and which thus ensure lateral injection of charge carriers into the central segment,
where
the semiconductor membrane (20) is produced based on crystalline GaAs,
and the central segment (22) comprises GaAs-based quantum dots,
**characterized in that**
the doped lateral segments (21.1, 21.2) are produced based on AlₓGa₁₋ₓAs with a proportion of aluminium x comprised between 0.05 and 0.30.

2. Optoelectronic device (1) according to Claim 1, wherein the proportion of aluminium x is comprised between 0.10 and 0.25.

3. Optoelectronic device (1) according to Claim 1 or 2, wherein the electrodes (25) make contact with the doped lateral segments (21.1, 21.2).

4. Optoelectronic device (1) according to any one of Claims 1 to 3, comprising an intermediate layer (23), which is produced based on crystalline Al_{y}GaAs with a proportion of aluminium y higher than the proportion of aluminium x of the doped lateral segments (21.1, 21.2), and which lies between and makes contact with the first dielectric layer (14) on the one hand and the semiconductor membrane (20) on the other hand.

5. Optoelectronic device (1) according to any one of Claims 1 to 4, wherein the first and second dielectric layers (14, 26) are made of a material having a refractive index lower than that of the central segment (22).

6. Optoelectronic device (1) according to any one of Claims 1 to 5, wherein the carrier substrate (10) is an SOI substrate.

7. Optoelectronic device (1) according to any one of Claims 1 to 6, wherein the carrier substrate (10) comprises an integrated waveguide (13) optically coupled to an active waveguide formed by the central segment (22) of the semiconductor membrane (20).

8. Method of fabricating an optoelectronic device (1) according to any one of Claims 1 to 7, comprising the following steps:
∘ a) producing a semiconductor stack (30), comprising: a growth substrate (31); an etch-stop layer (32) grown epitaxially from the growth substrate (31), and an intermediate layer (23) based on epitaxially grown AIGaAs;
∘ b) transferring and joining the semiconductor stack (30) to the carrier substrate (10), the intermediate layer (23) being oriented toward the carrier substrate (10);
∘ c) removing the growth substrate (31) then the etch-stop layer (32);
∘ d) producing the semiconductor membrane (20), from at least the intermediate layer (23);
∘ e) producing the second dielectric layer (26) and the electrodes (25).

9. Fabricating method according to Claim 8, wherein:
o in step a), the semiconductor stack (30) comprises a quantum-dot layer (33), which is intended to form the central segment (22), which is grown epitaxially from the etch-stop layer (32), and from which the intermediate layer (23) is grown epitaxially;
o following step c), one side of the quantum-dot layer (33) is freed;
o step d) comprises operations of: structuring the quantum-dot layer (33) to free a surface of the intermediate layer (23) and to obtain the central segment (22); and producing the doped lateral segments (21.1, 21.2) by epitaxy from the intermediate layer (23).

10. Fabricating method according to Claim 8, wherein:
o in step a), the semiconductor stack (30) comprises the intermediate layer (23) grown epitaxially from the etch-stop layer (32);
o following step c), one side of the intermediate layer (23) is freed;
o step d) comprises operations of: producing a quantum-dot layer (33) by epitaxy from the intermediate layer (23); structuring the quantum-dot layer (33) to free a surface of the intermediate layer (23) and to obtain the central segment (22); and producing the doped lateral segments (21.1, 21.2) by epitaxy from the intermediate layer (23).

11. Method of fabricating an optoelectronic device (1) according to any one of Claims 1 to 7, comprising the following steps:
∘ a) producing a semiconductor stack (30), comprising: a growth substrate (31), an etch-stop layer (32) grown epitaxially from the growth substrate (31), and a lateral structure grown epitaxially from the etch-stop layer (32) and formed from the central segment (22) and from doped lateral layers (35.1, 35.2) that are produced based on AlₓGa₁₋ₓAs and that are located on either side of the central segment (22) in the main plane;
∘ b) transferring and joining the semiconductor stack (30) to the carrier substrate (10), the intermediate layer (23) being oriented toward the carrier substrate (10);
∘ c) removing the growth substrate (31) then the etch-stop layer (32), freeing a side of the lateral structure opposite the carrier substrate (10);
∘ d) producing the semiconductor membrane (20), by structuring the doped lateral layers (35.1, 35.2) to obtain the doped lateral segments (21.1, 21.2);
∘ e) producing the second dielectric layer (26) and the electrodes (25).
